# EUROPEAN PATENT APPLICATION

(11) **EP 4 345 884 A1**
(43) Date of publication of application: **03.04.2024**
(21) Application number: 22198994.0
(22) Date of filing: 30.09.2022
(51) Int. Cl.: H01L 23/053, H01L 23/24, H01L 23/00, H05K 1/02, H01L 25/07, H01L 23/373

(54) **POWER SEMICONDUCTOR MODULE ARRANGEMENT AND PRINTED CIRCUIT BOARD FOR A POWER SEMICONDUCTOR MODULE ARRANGEMENT**

(71) Applicant: Infineon Technologies AG, 85579 Neubiberg (DE)
(72) Inventor: HOHLFELD, Olaf, 59581 Warstein (DE); BOENIG, Guido, 59581 Warstein (DE); MICHALSKI, Sebastian, 59557 Lippstadt (DE)
(74) Representative: Westphal, Mussgnug & Partner, Patentanwälte mbB

(57) **Abstract**

A power semiconductor module arrangement comprises a housing, a substrate arranged inside the housing, a printed circuit board arranged inside the housing distant from and in parallel to the substrate, one or more terminal elements, each terminal element having a first end and a second end, wherein either the first end is attached to the substrate, and the second end, at a first connection point, is attached to the printed circuit board, or the first end, at a second connection point, is attached to the printed circuit board, and the second end protrudes out of the housing, and an encapsulant at least partly filling the interior of the housing, thereby covering the substrate and the printed circuit board, wherein the printed circuit board comprises a main body and one or more sub-sections, wherein each of the one or more sub-sections is at least partly separated from the main body by one or more incisions.

## Description

### TECHNICAL FIELD

The instant disclosure relates to a semiconductor module arrangement, in particular to a semiconductor module arrangement comprising a printed circuit board, and to a printed circuit board for a power semiconductor module arrangement.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate.

Power semiconductor module arrangements often also include a printed circuit board arranged distant from and in parallel to the substrate inside the housing. Terminal elements that are used to transmit control signals between the substrate and the printed circuit board extend from the substrate to the printed circuit board and are electrically and mechanically attached to the substrate as well as to the printed circuit board. Power semiconductor module arrangements generally further include an encapsulant. The encapsulant may at least partly fill the interior of the housing, thereby covering the substrate, the components and electrical connections that are arranged on the substrate, as well as the printed circuit board that is arranged inside the housing and any elements mounted thereon in order to protect the different elements from certain environmental conditions and mechanical damage. However, during the use of the power semiconductor module arrangement, heat is generated. The encapsulant generally has an expansion coefficient that is significantly higher than the expansion coefficient of the printed circuit board and the substrate (e.g., four to six times higher). The material of the encapsulant expands at higher temperatures, and contracts when it cools down again, wherein the expansion and contraction is significantly stronger than the expansion/contraction of the other components of the power semiconductor module arrangement. The printed circuit board, which is firmly attached to the substrate by means of the terminal elements, therefore is exposed to very high tensions when the material of the encapsulant expands/contracts. This may result in damages of the printed circuit board, of the mechanical contacts between the printed circuit board and the terminal elements, or of the encapsulant itself, which may ultimately lead to a failure of the power semiconductor module arrangement.

There is a need for a power semiconductor module arrangement with a printed circuit board arranged inside the housing that avoids the drawbacks mentioned above.

### SUMMARY

A power semiconductor module arrangement includes a housing, a substrate arranged inside the housing, a printed circuit board arranged inside the housing distant from and in parallel to the substrate, one or more terminal elements, each terminal element having a first end and a second end, wherein either the first end is attached to the substrate, and the second end, at a first connection point, is attached to the printed circuit board, or the first end, at a second connection point, is attached to the printed circuit board, and the second end protrudes out of the housing, and an encapsulant at least partly filling the interior of the housing, thereby covering the substrate and the printed circuit board, wherein the printed circuit board includes a main body and one or more sub-sections, wherein each of the one or more sub-sections is at least partly separated from the main body by one or more incisions.

A printed circuit board for a power semiconductor module arrangement includes a main body and one or more sub-sections, wherein each of the one or more sub-sections is at least partly separated from the main body by one or more incisions.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a cross-sectional view of another power semiconductor module arrangement.
Figure 3 is a top view of a section of a printed circuit board.
Figure 4 is a top view of a section of a printed circuit board according to one example.
Figure 5 is a top view of a section of a printed circuit board according to another example.
Figure 6 schematically illustrates a cross-sectional view of a printed circuit board according to one example.
Figure 7 schematically illustrates a top view of a printed circuit board according to one example.
Figure 8 schematically illustrates a cross-sectional view of a printed circuit board according to another example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

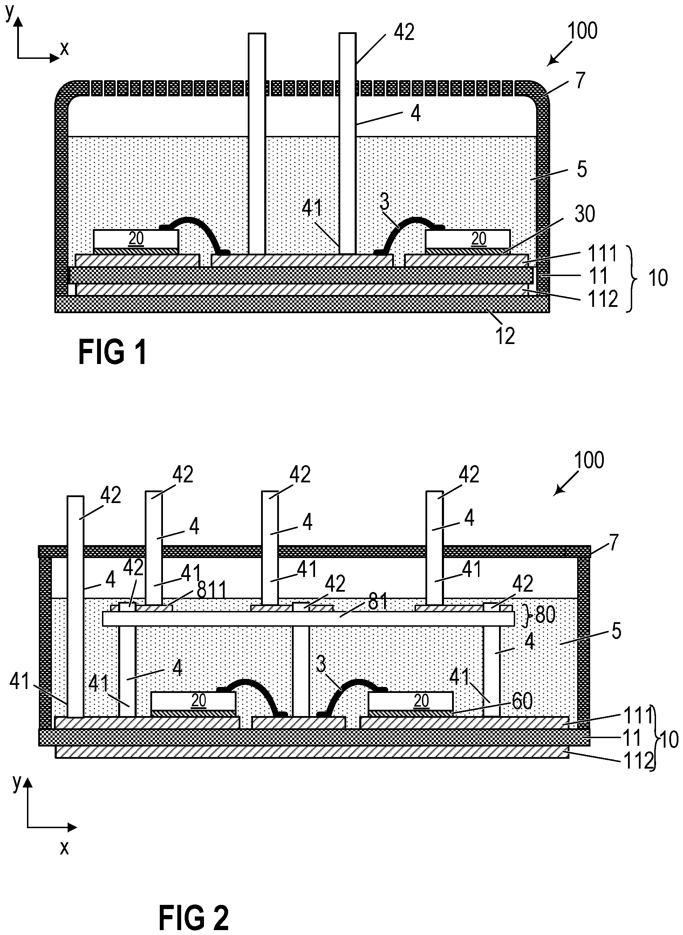

Referring to Figure 1, a cross-sectional view of a power semiconductor module arrangement 100 is schematically illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 12 which forms a ground surface of the housing 7, while the housing 7 itself solely comprises sidewalls and a cover. This is, however, only an example. It is also possible that the housing 7 further comprises a ground surface and the substrate 10 and the base plate 12 be arranged inside the housing 7. In some power semiconductor module arrangements 100, more than one substrate 10 is arranged on a single base plate 12 or on the ground surface of a housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), and/or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. This, however, is only an example. Any other number of sections is possible. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Electrical connections 3 may also include connection plates or conductor rails, for example, to name just a few examples. The one or more semiconductor bodies 20 may be electrically and mechanically connected to the substrate 10 by an electrically conductive connection layer 30. Such an electrically conductive connection layer 30 may be a solder layer, a layer of an electrically conductive adhesive, or a layer of a sintered metal powder, e.g., a sintered silver powder, for example.

According to other examples, it is also possible that the second metallization layer 112 is a structured layer. It is further possible to omit the second metallization layer 112 altogether. It is generally also possible that the first metallization layer 111 is a continuous layer, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of each of the terminal elements 4 protrudes out of the housing 7. The terminal elements 4 may be electrically contacted from the outside at their respective second ends 42. A first part of the terminal elements 4 may extend through the inside of the housing 7 in a vertical direction y. The vertical direction y is a direction perpendicular to a top surface of the substrate 10, wherein the top surface of the substrate 10 is a surface on which the at least one semiconductor body 20 is mounted. The terminal elements 4 illustrated in Figure 1, however, are only examples. Terminal elements 4 may be implemented in any other way and may be arranged anywhere within the housing 7. For example, one or more terminal elements 4 may be arranged close to or adjacent to the sidewalls of the housing 7. Terminal elements 4 could also protrude through the sidewalls of the housing 7 instead of through the cover. The first end 41 of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end 41 of a terminal element 4 may also be electrically coupled to the substrate 10 via one or more electrical connections 3, for example. For example, the second ends 42 of the terminal elements 4 may be connected to a printed circuit board (not illustrated in Figure 1).

The power semiconductor module arrangement 100 further includes an encapsulant 5. The encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their second ends 42, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged on the substrate 10 inside the housing 7, from certain environmental conditions and mechanical damage.

Now referring to Figure 2, another power semiconductor module arrangement 100 is schematically illustrated. The power semiconductor module arrangement 100 of Figure 2 essentially corresponds to the power semiconductor module arrangement 100 that has been explained with respect to Figure 1 above. However, the power semiconductor module arrangement 100 illustrated in Figure 2 further comprises a printed circuit board 80. The printed circuit board 80 is coupled to a first subset of the terminal elements 4 and is arranged inside the housing 7. The first subset of the terminal elements 4 may comprise shorter terminal elements 4 that are arranged entirely inside the housing 7. The first subset of the terminal elements 4, however, may also extend from the substrate 10 through a through hole in the printed circuit board 80 to the outside of the housing 7 (not specifically illustrated in Figure 2). A second, optional subset of the terminal elements 4, may extend from the substrate 10 to the outside of the housing 7, without contacting the printed circuit board 80 in any way (see terminal element 4 on the far left side of Figure 2).

One or more terminal elements 4 of another subset of terminal elements 4 may be mechanically and electrically coupled to the printed circuit board 80 with their first ends 41, while their second end 42 extends to the outside of the housing 7, allowing to electrically contact the printed circuit board 80 from the outside of the housing 7. By arranging a printed circuit board 80 inside the housing 7, the power semiconductor module arrangement 100 can be implemented in a compact and space saving way. This is, because at least a subset of a plurality of components that is usually arranged on the substrate 10 or on an external printed circuit board (printed circuit board that is arranged outside of the housing 7) can be arranged on the printed circuit board 80 inside the housing 7 instead of on the substrate 10 or on an external printed circuit board. The size of the substrate 10 and/or an external printed circuit board (not specifically illustrated), therefore, can be reduced as compared to arrangements only comprising a substrate 10, or a substrate 10 and an external printed circuit board outside the housing 7 but not the printed circuit board 80 inside the housing 7.

In order to protect the printed circuit board 80 inside the housing 7 and the components arranged on the printed circuit board 80 from certain environmental conditions and mechanical damage, the printed circuit board 80 may also be covered by the encapsulant 5 that has been described with respect to Figure 1 above. During the use of the power semiconductor module arrangement 100, the elements arranged on the substrate 10 and on the printed circuit board 80 generate heat. Heat generated by the elements arranged on the substrate 10 and/or on the printed circuit board 80 is transferred through the encapsulant 5 and causes the encapsulant 5, which has a certain expansion coefficient, to expand. When the power semiconductor module arrangement subsequently cools down again, the encapsulant 5 contracts again. The expansion coefficient of the encapsulant 5 (e.g., silicone gel) is usually significantly higher than the expansion coefficient of the materials used for the substrate 10 and the printed circuit board 80, e.g., four to six times higher. Therefore, the encapsulant 5 expands and contracts significantly more than the substrate 10 and the printed circuit board 80. The printed circuit board 80, which is usually comparably rigid, therefore, is exposed to high tensions and stress, which may lead to a malfunctioning or even to a complete failure of the power semiconductor module arrangement 100.

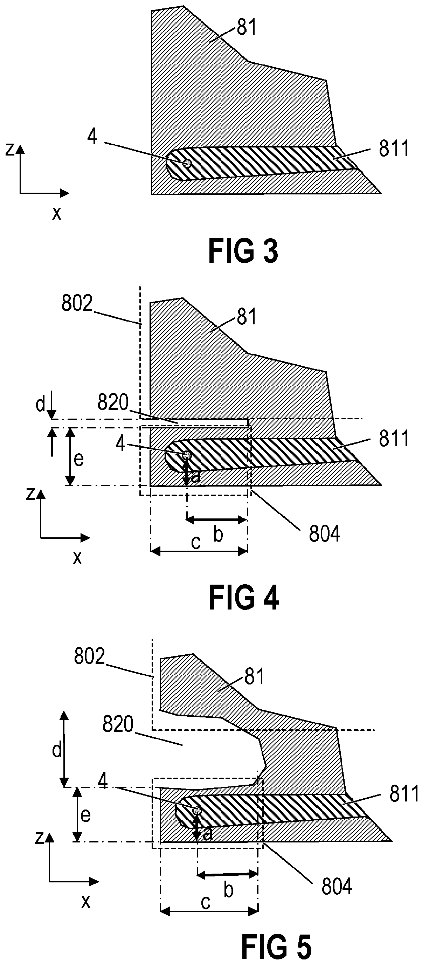

A printed circuit board 80, as is schematically illustrated in Figure 3, may comprise a dielectrically insulating layer 81 and one or more electrically conducting paths 811 arranged on the dielectrically insulating layer 81. The dielectrically insulating layer 81 usually has a comparably large cross-sectional area. The dielectrically insulating layer 81 often has a square or rectangular cross-section. A section of a printed circuit board 80 comprising a first connection point is schematically illustrated in Figure 3. The first connection point is a point at which a terminal element 4 is connected to the printed circuit board 80. As has been described above with respect to Figure 2, a terminal element 4 is not only connected to the printed circuit board 80. One or more terminal elements 4 are also connected to the substrate 10 with their first ends 41. The printed circuit board 80, therefore, is firmly held in place with respect to the substrate 10 by means of one or more terminal elements 4. This is the reason why the entire printed circuit board 80 is in a fixed position and cannot move together with the encapsulant 5, as the encapsulant 5 expands or contracts.

In order to allow a movement of at least parts of the printed circuit board 80, the printed circuit board 80 according to one example comprises a main body 802 and one or more sub-sections 804, wherein each of the one or more sub-sections 804 is at least partly separated from the main body 802 by one or more incisions 820. Only a section of the main body 802 and a sub-section 804 according to one example are illustrated in Figures 4 and 5. A sub-section 804 may be connected to the main body 802 via a comparably thin joint, for example. In this way, the one or more sub-sections 804 allow a certain movement of the main body 802. The comparably thin joint between a sub-section 804 and the main body 802 is more flexible than any sections of a conventional printed circuit board 80 comprising only a large coherent main body. Each sub-section 804 may comprise at least one of the first connection points. That is, the one-or more sub-sections 804 are essentially held in place by means of the terminal elements 4 connected to the respective first connection points. The main body 802, however, may move to a certain degree when the encapsulant 5 expands or contracts, as the main body 802 is somewhat flexible with regard to each of the at least one sub-section 804. The printed circuit board 80 and any components mounted thereon, therefore, are less prone to any damages or failures.

The one or more sub-sections 804 may be implemented in any suitable way. Figure 4 schematically illustrates a sub-section 804 of a first kind. The sub-section 804 in this example is an elongated sub-section 804. That is, a length c of the sub-section 804 in a first horizontal direction x is larger than a width e of the sub-section 804 in a second horizontal direction z that is perpendicular to the first horizontal direction x. The length c of an elongated sub-section 804 may be at least twice its width e, at least three times its width e or at least five times its width e, for example. According to one example, a length c of an elongated sub-section 804 (sub-section 804 of the first type) in the first horizontal direction x may be at least 5mm, or at least 10mm.

An incision 820 may be an essentially thin cut, as is schematically illustrated in Figure 4. A length of the incision 820 in this example corresponds to the length c of the sub-section 804. A width d of the incision 820 may be significantly smaller. According to one example, a width d of an incision 820 is less than 2mm, or less 1mm. In this way, more area of the printed circuit board 80 remains such that more elements may be arranged on the printed circuit board 80. It is, however, also possible that an incision 820 has a comparably large width d, as is schematically illustrated in Figure 5. The width d of the incision 820 generally has no influence on the function and flexibility of the respective sub-section 804. An incision 820 may be larger, for example, when this is required for design reasons. For example, recesses may be formed in the printed circuit board 80 by means of the incisions 820 in order to make space for other elements of the power semiconductor module arrangement. As has been described above, some terminal elements 4 may extend from the substrate 10 to the outside of the housing 7 without contacting the printed circuit board 80 at all. Such terminal elements 4 may be arranged in the area of a larger incisions 820, for example. It is also possible that any< kind of structural elements of a housing 7, for example, be arranged in the area of a larger incision 820.

The one or more sub-sections 804 need to provide a certain stability in order to be able to connect the respective terminal elements 4 thereto, without damaging the sub-sections 804. If a sub-section 804 is very thin, for example, there may be a risk that it is demolished or even torn off while connecting one or more terminal elements 4 thereto. Therefore, a shortest distance a between a first connection point and an incision 820 may be at least 1mm, or at least 2.5mm. These values, however, further depend on other parameters of the printed circuit board 80 such as, e.g., a material and a thickness t81 of the dielectrically insulating layer 81.

The dielectrically insulating layer 81 may comprise a cured resin, or a polymer filled with glass fiber, for example. Any other suitable dielectrically insulating non-ceramic materials, however, are also possible. The dielectrically insulating layer 81 may have a thickness t81 of between 0.5 and 2mm in a vertical direction y, for example, wherein the vertical direction is perpendicular to the first horizontal direction (x) and the second horizontal direction y.

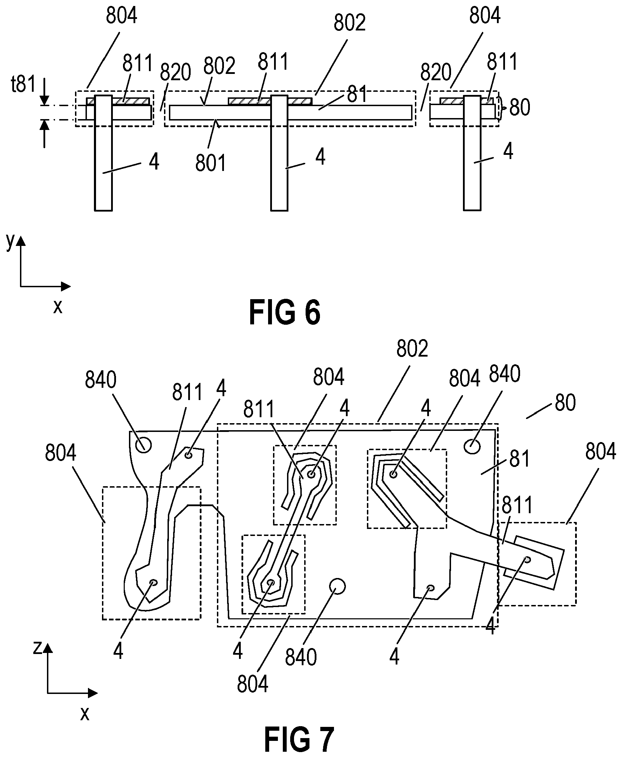

The dielectrically insulating layer 81 generally comprises a first surface 801 facing the substrate 10, and a second surface 802 opposite the first surface 801, the second surface 802 facing away from the substrate 10. Each of the one or more incisions 820 extends from the first surface 801 to the second surface 802 through an entire thickness t81 of the dielectrically insulating layer 81. This is schematically illustrated in the cross-sectional view of Figure 6. The one or more electrically conducting paths 811 are usually arranged on the second surface 802 facing away from the substrate 10. Conducting paths 811, alternatively or additionally, however may also be arranged on the first surface 801. The conducting paths 811 generally do not cover the entire first or second surface 801, 802. The conducting paths 811 are configured to conduct electrical signals from one component (e.g., terminal element 4 or any other component that may be mounted on the printed circuit board 80) to another.

The sub-sections 804 of the first kind as schematically illustrated in Figures 4 and 5, however, are only an example. In the examples of Figures 4 and 5, as well as in Figure 7, left side, the one or more sub-sections 804 of the first kind may be arranged towards an edge of the printed circuit board 80. That is, an incision 820 formed in the printed circuit board 80 to define the respective sub-sections 804 may have an essentially elongated form. As is schematically illustrated in Figure 7, center, it is also possible that at least one of the at least one sub-section 804 of the first type is partly separated from the main body 802 by a U-shaped or V-shaped incision 820. In this example, the respective sub-section 804 is entirely surrounded by the main body 802. Terminal elements 4 are not always only arranged towards the edges of a printed circuit board 80. Terminal elements 4 may also be connected to central portions of a printed circuit board 80. By separating a sub-section 804 from the main body 802 by means of a U-shaped or V-shaped incision 820, a flexible portion can also be formed in central parts of the printed circuit board 80. The main body 802 of the printed circuit board 80 that surrounds the respective sub-section 804 in a horizontal plane may move together with the expansion and contraction of the encapsulant 5 to a certain degree, while the sub-section 804 essentially remains in its position, as it is attached to the substrate 10 by means of one or more terminal elements 4. Such sub-sections 804 also have an essentially elongated shape, similar to what has been described with respect to Figures 4 and 5 above.

The elongated sub-sections 804 of the first kind generally have the shape of a peninsula. That is, the sub-sections 804 of the first kind each are connected to the main body 802 by means of a thin joint formed by the dielectrically insulating layer 81 and at least one electrically conducting path 811. As is schematically illustrated in Figure 7, right side, the power semiconductor module arrangement may further comprise one or more sub-sections 804 of a second kind. Each of the at least one sub-section 804 of the second kind is connected to the main body 802 solely by means of at least one electrically conducting path 811. That is, a section of the dielectrically insulating layer 81 is completely separated from other parts of the dielectrically insulating layer 81. An electrical connection between a sub-section 804 of the second kind and the main body 802, however, is provided by means of one or more conducting paths 811. The main body 802 in this example can move comparably independent from the respective sub-section 804. A conducting path 811 is usually formed by a comparably thin metallic layer that is generally more flexible than the material of the dielectrically insulating layer 81. As has been described above, conducting paths 811 may be arranged on the second surface 802 of the dielectrically insulating layer 81 facing away from the substrate 10. Conducting paths 811, alternatively or additionally, however may also be arranged on the first surface 801 of the dielectrically insulating layer 81.

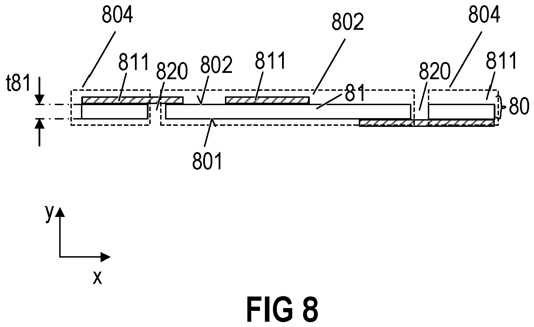

Figure 8, in a side view, schematically illustrates sub-sections 804 of the second kind in further detail. As can be seen, a first sub-section 804 of the second kind is connected to the main body 802 by means of an electrically conducting path 811 arranged on the second surface 802. A second sub-section 804 of the second kind in this example is connected to the main body 802 by means of an electrically conducting path 811 arranged on the first surface 801.

As has been described with respect to Figure 2 above, the power semiconductor module arrangement may further comprise terminal elements 4 that are connected to the printed circuit board 80 with a first end 41, while a second end 42 of the terminal elements protrudes out of the housing 7 to allow the printed circuit board 80 to be contacted from the outside of the housing 7. The first end 41 of each of such additional terminal elements 4 may be connected to the printed circuit board 80 at a second connection point. Sub-sections 804, similar to what has been described above, may also be formed for sections of the printed circuit board 80 comprising such second connection points.

When one or more incisions 820 are formed in the printed circuit board 80, the overall surface area of the printed circuit board 80 is reduced as compared to a conventional printed circuit board 80 having, e.g., a square or rectangular cross-section. That is, the contact surface between the encapsulant 5 and the printed circuit board 80 is reduced. In this way, the encapsulant 5 generally exerts less forces on the printed circuit board 80 when expanding or contracting, further reducing the risk of damages and/or failures.

## Claims

1. A power semiconductor module arrangement comprises,
a housing (7);
a substrate (10) arranged inside the housing (7);
a printed circuit board (80) arranged inside the housing (7) distant from and in parallel to the substrate (10);
one or more terminal elements (4), each terminal element (4) having a first end (41) and a second end (42), wherein either the first end (41) is attached to the substrate (10), and the second end (42), at a first connection point, is attached to the printed circuit board (80), or the first end (41), at a second connection point, is attached to the printed circuit board (80), and the second end (42) protrudes out of the housing (7); and
an encapsulant (5) at least partly filling the interior of the housing (7), thereby covering the substrate (10) and the printed circuit board (80), wherein
the printed circuit board (80) comprises a main body (802) and one or more sub-sections (804), wherein each of the one or more sub-sections (804) is at least partly separated from the main body (802) by one or more incisions (820).

2. The power semiconductor module arrangement of claim 1, wherein each sub-section (804) comprises at least one first connection point and/or at least one second connection point.

3. The power semiconductor module arrangement of claim 1 or 2, wherein the printed circuit board (80) comprises a dielectrically insulating layer (81) and one or more electrically conducting paths (811) arranged on the dielectrically insulating layer (81).

4. The power semiconductor module arrangement of claim 3, wherein the dielectrically insulating layer (81) comprises a cured resin, or a polymer filled with glass fiber.

5. The power semiconductor module arrangement of claim 3 or 4, wherein the dielectrically insulating layer (81) comprises a first surface (801) facing the substrate (10), and a second surface (802) opposite the first surface (801), the second surface (802) facing away from the substrate (10), and wherein each of the one or more incisions (820) extends from the first surface (801) to the second surface (802) through an entire thickness (t81) of the dielectrically insulating layer (81).

6. The power semiconductor module arrangement of any of claims 3 to 5, comprising at least one sub-section (804) of a first type, wherein each of the at least one sub-section (804) of the first type is an elongated sub-section (804) and is connected to the main body (802) by means of the dielectrically insulating layer (81) and at least one electrically conducting path (811).

7. The power semiconductor module arrangement of claim 6, wherein a length of an incision (820) partly separating a sub-section (804) of the first type from the main body (802) corresponds to a length (c) of the sub-section (804) of the first type in a first horizontal direction (x).

8. The power semiconductor module arrangement of claim 6 or 7, wherein a length (c) of each of the at least one sub-section (804) of the first type in a first horizontal direction (x) is at least 5mm, or at least 10mm.

9. The power semiconductor module arrangement of claim 7 or 8, wherein each sub-section (804) of the first type has a width (e) in a second horizontal direction (z) that is perpendicular to the first horizontal direction (x), and wherein the length (c) of each of the at least one sub-section (804) of the first type is at least twice its width (e), at least three times its width (e) or at least five times its width (e).

10. The power semiconductor module arrangement of claim 6, wherein at least one of the at least one sub-section (804) of the first type is partly separated from the main body (802) by a U-shaped or V-shaped incision (820).

11. The power semiconductor module arrangement of any of claims 3 to 5, comprising at least one sub-section (804) of a second type, wherein each of the at least one sub-section (804) of the second type is connected to the main body (802) solely by means of at least one electrically conducting path (811).

12. The power semiconductor module arrangement of any of the preceding claims, wherein a shortest distance (a) between an incision (820) and a first connection point or a second connection point is at least 1mm, or at least 2.5mm.

13. The power semiconductor module arrangement of any of claims 3 to 12, wherein the dielectrically insulating layer (81) has a thickness (t81) of between 0.5 and 2mm in a vertical direction (y), wherein the vertical direction is perpendicular to the first horizontal direction (x) and the second horizontal direction (y).

14. A printed circuit board (80) for a power semiconductor module arrangement, the printed circuit board (80) comprising:
a main body (802); and
one or more sub-sections (804), wherein each of the one or more sub-sections (804) is at least partly separated from the main body (802) by one or more incisions (820).

## Amended claims

### Amended claims in accordance with Rule 137(2) EPC.

1. A power semiconductor module arrangement comprises,
a housing (7);
a substrate (10) arranged inside the housing (7);
a printed circuit board (80) arranged inside the housing (7) distant from and in parallel to the substrate (10);
one or more terminal elements (4), each terminal element (4) having a first end (41) and a second end (42), wherein either the first end (41) is attached to the substrate (10), and the second end (42), at a first connection point, is attached to the printed circuit board (80), or the first end (41), at a second connection point, is attached to the printed circuit board (80), and the second end (42) protrudes out of the housing (7); and
an encapsulant (5) at least partly filling the interior of the housing (7), thereby covering the substrate (10) and the printed circuit board (80), wherein
the printed circuit board (80) comprises a main body (802) and one or more sub-sections (804), wherein each of the one or more sub-sections (804) is at least partly separated from the main body (802) by one or more incisions (820),
each sub-section (804) comprises at least one first connection point and/or at least one second connection point,
the printed circuit board (80) comprises a dielectrically insulating layer (81) and one or more electrically conducting paths (811) arranged on the dielectrically insulating layer (81),
the dielectrically insulating layer (81) comprises a first surface (801) facing the substrate (10), and a second surface (802) opposite the first surface (801), the second surface (802) facing away from the substrate (10), and wherein each of the one or more incisions (820) extends from the first surface (801) to the second surface (802) through an entire thickness (t81) of the dielectrically insulating layer (81), and
either the printed circuit board (80) comprises at least one sub-section (804) of a first type, wherein each of the at least one sub-section (804) of the first type is an elongated sub-section (804) and is connected to the main body (802) by means of the dielectrically insulating layer (81) and at least one electrically conducting path (811), wherein at least one of the at least one sub-section (804) of the first type is partly separated from the main body (802) by a U-shaped or V-shaped incision (820), and wherein each of the at least one sub-section (804) is entirely surrounded by the main body (802), or
the printed circuit board (80) comprises at least one sub-section (804) of a second type, wherein each of the at least one sub-section (804) of the second type is connected to the main body (802) solely by means of at least one electrically conducting path (811).

2. The power semiconductor module arrangement of claim 1, wherein the dielectrically insulating layer (81) comprises a cured resin, or a polymer filled with glass fiber.

3. The power semiconductor module arrangement of claim 1, the power semiconductor module arrangement comprises at least one sub-section (804) of the first type, and wherein a length of an incision (820) partly separating a sub-section (804) of the first type from the main body (802) corresponds to a length (c) of the sub-section (804) of the first type in a first horizontal direction (x).

4. The power semiconductor module arrangement of claim 3, wherein a length (c) of each of the at least one sub-section (804) of the first type in a first horizontal direction (x) is at least 5mm, or at least 10mm.

5. The power semiconductor module arrangement of claim 3 or 4, wherein each sub-section (804) of the first type has a width (e) in a second horizontal direction (z) that is perpendicular to the first horizontal direction (x), and wherein the length (c) of each of the at least one sub-section (804) of the first type is at least twice its width (e), at least three times its width (e) or at least five times its width (e).

6. The power semiconductor module arrangement of any of the preceding claims, wherein a shortest distance (a) between an incision (820) and a first connection point or a second connection point is at least 1mm, or at least 2.5mm.

7. The power semiconductor module arrangement of any of the preceding claims, wherein the dielectrically insulating layer (81) has a thickness (t81) of between 0.5 and 2mm in a vertical direction (y), wherein the vertical direction is perpendicular to the first horizontal direction (x) and the second horizontal direction (y).

8. A printed circuit board (80) for a power semiconductor module arrangement, the printed circuit board (80) comprising:
a main body (802); and
one or more sub-sections (804), wherein
each of the one or more sub-sections (804) is at least partly separated from the main body (802) by one or more incisions (820),
each sub-section (804) comprises at least one first connection point and/or at least one second connection point,
the printed circuit board (80) comprises a dielectrically insulating layer (81) and one or more electrically conducting paths (811) arranged on the dielectrically insulating layer (81),
the dielectrically insulating layer (81) comprises a first surface (801) and a second surface (802) opposite the first surface (801), wherein each of the one or more incisions (820) extends from the first surface (801) to the second surface (802) through an entire thickness (t81) of the dielectrically insulating layer (81), and
either the printed circuit board (80) comprises at least one sub-section (804) of a first type, wherein each of the at least one sub-section (804) of the first type is an elongated sub-section (804) and is connected to the main body (802) by means of the dielectrically insulating layer (81) and at least one electrically conducting path (811), wherein at least one of the at least one sub-section (804) of the first type is partly separated from the main body (802) by a U-shaped or V-shaped incision (820), and wherein each of the at least one sub-section (804) is entirely surrounded by the main body (802), or
the printed circuit board (80) comprises at least one sub-section (804) of a second type, wherein each of the at least one sub-section (804) of the second type is connected to the main body (802) solely by means of at least one electrically conducting path (811).
